Europäisches Patentamt

European Patent Office

Office européen des brevets

(19)

(11) **EP 0 989 675 A1**

(12) **DEMANDE DE BREVET EUROPEEN**

(43) Date de publication:
**29.03.2000 Bulletin 2000/13**

(51) Int. Cl.⁷: **H03L 7/113**

(21) Numéro de dépôt: **98460039.5**

(22) Date de dépôt: **21.09.1998**

(84) Etats contractants désignés:
**AT BE CH CY DE DK ES FI FR GB GR IE IT LI LU MC NL PT SE**
Etats d'extension désignés:
**AL LT LV MK RO SI**

(71) Demandeur:
**TRT Lucent Technologies (SA)**
**92359 Le Plessis Robinson (FR)**

(72) Inventeur: **Laffont, Jean**
**78530 Bois d'Arcy (FR)**

(74) Mandataire: **Ballot, Paul et al**
**Cabinet Ballot-Schmit,**
**4 Rue Général Hoche**
**56100 Lorient (FR)**

(54) **Dispositif de prépositionnement en fréquence d'un oscillateur commandé en tension**

(57) La présente invention concerne un dispositif de prépositionnement en fréquence d'un oscillateur (VCO) commandé en tension comportant une boucle d'asservissement (ASS). Ce dispositif est destiné à prépositionner ledit oscillateur commandé en tension (VCO) dans une plage de fréquences [f1,f2], avec f1<f2, correspondant à la plage de fonctionnement correct de ladite boucle d'asservissement dudit oscillateur. Il est caractérisé en ce qu'il comporte des premier et second moyens (M1,M2) formant avec ledit oscillateur commandé en tension (VCO) des première et seconde boucles de verrouillage de phase, lesdites première et seconde boucles de verrouillage de phase étant destinées à verrouiller l'oscillateur commandé en tension sur les fréquences f1 et f2 respectivement, ledit premier moyen (M1) comportant des moyens pour désactiver la première boucle de verrouillage lorsque la fréquence de l'oscillateur commandé en tension (VCO) est supérieure ou égale à f1 et ledit second moyen (M2) comportant des moyens pour désactiver la seconde boucle de verrouillage lorsque la fréquence de l'oscillateur commandé en tension (VCO) est inférieure ou égale à f2.

Applications: démodulation cohérente, boucles de Costas...

FIG. UNIQUE

EP 0 989 675 A1

**Description**

La présente invention concerne un dispositif de prépositionnement en fréquence d'un oscillateur commandé en tension.

Les oscillateurs commandés en tension, appelés couramment VCO (Voltage Controlled Oscillator), sont très utilisés dans les dispositifs de démodulation de phase cohérente tels que les circuits à boucle de Costas, pour effectuer la récupération de porteuse. Dans ce type de dispositif, l'oscillateur commandé en tension est asservi par une boucle d'asservissement. Pour obtenir un fonctionnement correct du dispositif dès sa mise en marche, il est généralement nécessaire de prépositionner en fréquence l'oscillateur commandé en tension sur une plage de fréquences relativement étroite [f1,f2] correspondant à la plage de fonctionnement de la boucle d'asservissement.

Pour éviter cette opération de prépositionnement, on pourrait alors envisager d'utiliser un oscillateur commandé en tension intrinsèquement stable en température et dans le temps (vieillissement) dont la fréquence libre f0 serait proche de la plage [f1,f2]. Il se révèle néanmoins que ce type d'oscillateur est d'autant plus difficile à concevoir que les fréquences f1,f2 sont élevées et que le débit numérique du signal est faible. Ce type d'oscillateur est par conséquent très difficilement reproductible. Aussi, existe-t-il déjà des dispositifs de recherche de la plage de capture de la boucle d'asservissement du système consistant à appliquer une rampe de tension sur l'entrée de commande de l'oscillateur commandé en tension. Ce type de dispositif présente cependant des risques de faux accrochage à des fréquences autres que la fréquence f0, pour lesquelles le comparateur de phase de ce dispositif présente une grande sensibilité.

Autrement, il existe également des dispositifs de prépositionnement en fréquence utilisant une boucle de verrouillage de phase pour verrouiller l'oscillateur commandé en tension sur une fréquence f comprise entre f1 et f2. Cependant, une fois la fréquence de verrouillage atteinte, la boucle de verrouillage de phase ne se "coupe" pas naturellement et nécessite un système relativement complexe pour couper la boucle de verrouillage de phase et commuter l'oscillateur sur la boucle d'asservissement.

Aussi, la présente invention vise à pallier ces inconvénients de l'état antérieur de la technique en proposant un dispositif de prépositionnement qui soit automatique et simple à mettre en oeuvre.

L'invention a donc pour objet un dispositif de prépositionnement en fréquence d'un oscillateur commandé en tension et comportant une boucle d'asservissement, lequel dispositif est destiné à prépositionner ledit oscillateur commandé en tension dans une plage de fréquences [f1,f2], avec f1<12, correspondant à la plage de fonctionnement correct de ladite boucle d'asservissement dudit oscillateur, et est caractérisé en ce qu'il comporte des premier et second moyens formant avec ledit oscillateur commandé en tension des première et seconde boucles de verrouillage de phase, lesdites première et seconde boucles de verrouillage de phase étant destinées à verrouiller l'oscillateur commandé en tension sur les fréquences f1 et f2 respectivement, ledit premier moyen comportant des moyens pour désactiver la première boucle de verrouillage lorsque la fréquence de l'oscillateur commandé en tension est supérieure ou égale à f1 et ledit second moyen comportant des moyens pour désactiver la seconde boucle de verrouillage lorsque la fréquence de l'oscillateur commandé en tension est inférieure ou égale à f2.

Ainsi, lorsque la fréquence de l'oscillateur commandé en tension est dans l'intervalle [f1,f2], l'action des deux boucles de verrouillage de phase sur l'oscillateur commandé en tension est interrompue.

Dans un mode de réalisation préféré, le premier moyen comporte

- un premier bloc de comparaison pour comparer la fréquence de l'oscillateur commandé en tension avec la fréquence f1 délivrant une tension de commande positive à l'oscillateur commandé en tension lorsque la fréquence de celui-ci est inférieure à f1, et
- une première diode intercalée entre le premier bloc de comparaison et l'oscillateur commandé en tension, ladite première diode étant polarisée de manière à être bloquée et à désactiver la première boucle de verrouillage de phase lorsque la fréquence de l'oscillateur commandé en tension est supérieure ou égale à f1,

  et en ce que le second moyen comporte
- un second bloc de comparaison pour comparer la fréquence de l'oscillateur commandé en tension avec la fréquence f2 délivrant une tension de commande positive à l'oscillateur commandé en tension lorsque la fréquence de celui-ci est inférieure à f2, et
- une seconde diode intercalée entre le second bloc de comparaison et l'oscillateur commandé en tension, ladite seconde diode étant polarisée de manière à être bloquée et à désactiver la première boucle de verrouillage de phase lorsque la fréquence de l'oscillateur commandé en tension est inférieure ou égale à f2.

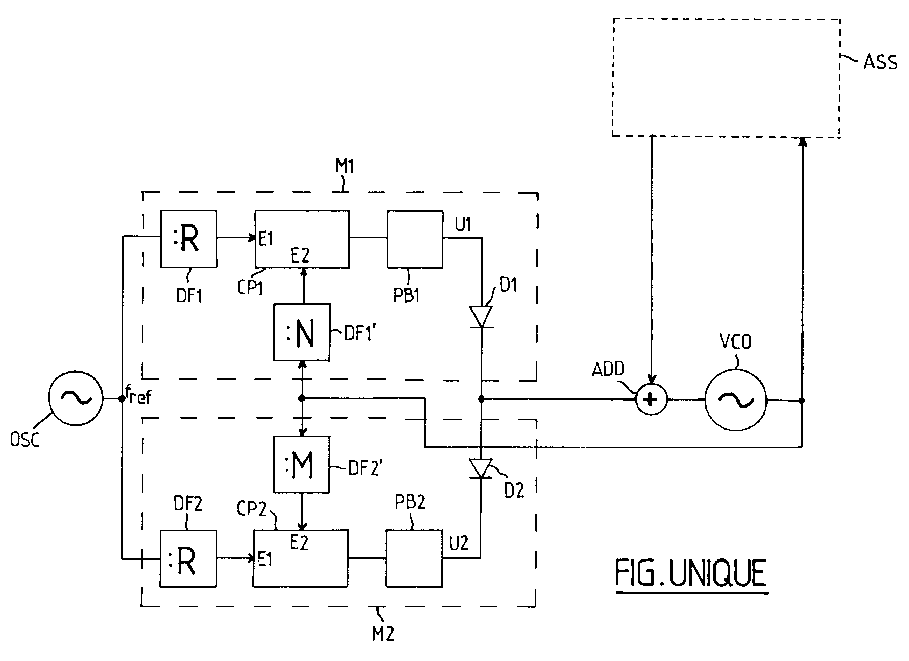

D'autres caractéristiques et avantages de l'invention apparaîtront à la lecture de la description détaillée qui suit et qui est faite en référence à la figure unique qui représente un schéma d'un dispositif de prépositionnement en fréquence selon l'invention.

Selon l'invention, l'oscillateur commandé en tension est inséré dans deux boucles de verrouillage de phase agissant sur l'entrée de commande de celui-ci lorsque la fréquence de son signal de sortie est en dehors de l'intervalle [f1,f2] avec f1<f2.

Un mode de réalisation du dispositif de prépositionnement en fréquence selon l'invention est représenté sur la figure unique. L'oscillateur commandé en tension, VCO, à positionner en fréquence est utilisé dans une boucle d'asservissement ASS, par exemple une boucle de Costas.

Le dispositif de l'invention comprend des premier et second moyens M1, M2 formant respectivement avec l'oscillateur commandé en tension, VCO, des première et seconde boucles de verrouillage de phase que nous appellerons PLL1 et PLL2. La boucle de verrouillage de phase PLL1 agit sur l'entrée de commande de l'oscillateur VCO lorsque la fréquence f du signal issu de ce dernier est inférieure à f1 au contraire de la boucle de verrouillage de phase PLL2 qui intervient dans la commande de l'oscillateur VCO lorsque la fréquence f est supérieure à f2.

Le moyen M1 comprend un comparateur phase/fréquence CP1 dont une première entrée E1 est connectée à la sortie d'un oscillateur OSC délivrant un signal de référence de fréquence $f_{ref}$ via un premier diviseur de fréquence DF1 et dont une seconde entrée E2 est connectée à la sortie de l'oscillateur VCO via un second circuit diviseur de fréquence DF1'. Dans cet exemple, le diviseur DF1 est chargé de diviser la fréquence $f_{ref}$ par R tandis que le diviseur DF1' divise la fréquence f du signal de sortie de l'oscillateur VCO par N. La boucle PLL1 est donc prévue pour se verrouiller sur la fréquence $f1 = N.f_{ref}/R$. La sortie du comparateur CP1 est reliée à un filtre passe-bas PB1 chargé de ne laisser passer que la composante continue U1 du signal issu du comparateur CP1. Cette tension continue U1 est ensuite additionnée au moyen d'un circuit additionneur ADD à la tension issue de la boucle d'asservissement ASS puis la tension résultante est appliquée sur l'entrée de commande de l'oscillateur VCO.

Pour que cette boucle de verrouillage de phase n'agisse sur l'oscillateur VCO que lorsque f>f1, le moyen M1 est complété par une diode D1 qui est intercalée entre le filtre PB1 et l'additionneur ADD. Cette diode est polarisée de manière à être bloquée lorsque f>f1. Par conséquent, son anode est reliée à la sortie du filtre PB1 et sa cathode est reliée à une des entrées de l'additionneur ADD.

La structure du moyen M2 formant avec l'oscillateur VCO une seconde boucle de verrouillage de phase PLL2 est globalement la même que celle du moyen M1. Il comporte un comparateur phase/fréquence CP2 dont l'entrée E1 est connectée via un diviseur de fréquence DF2 à la sortie de l'oscillateur OSC et dont l'entrée E2 est connectée via un diviseur de fréquences DF2' à la sortie de l'oscillateur VCO. Les diviseurs de fréquences DF2 et DF2' effectuent respectivement une division par R et par N. La boucle PLL2 est prévue pour se verrouiller sur la fréquence $f2 = M.f_{ref}/R$. La sortie du comparateur CP2 est reliée à un filtre passe-bas PB2 chargé de ne laisser passer que la composante continue U2 du signal issu du comparateur CP2. Cette composante continue est additionnée au moyen de l'additionneur ADD à la tension issue de la boucle d'asservissement ASS, la tension résultante étant appliquée à l'entrée de commande de l'oscillateur VCO.

Cette seconde boucle de verrouillage est prévue pour ne fonctionner que lorsque f>f2. Aussi, le moyen M2 est muni d'une diode D2 intercalée entre le filtre PB2 et l'additionneur ADD. Cette diode est polarisée de manière à être bloquée lorsque f<f2. C'est pourquoi sa cathode est reliée à la sortie du filtre PB2 et son anode est reliée à une des entrées de l'additionneur ADD.

Le dispositif fonctionne de la manière suivante:

- lorsque $f < f1 = N.f_{ref}/R$, la tension continue U1 issue du filtre PB1 est positive; la diode D1 est alors passante; la tension continue U2 issue du filtre PB2 est également positive car f1<f2; toutefois, la diode D2 étant polarisée en inverse, cette dernière est par conséquent bloquée; ainsi, seul le moyen M1 intervient dans la commande de l'oscillateur VCO et agit de manière à ce que la boucle de verrouillage de phase PLL1 ainsi formée se verrouille sur la fréquence f1;
- lorsque $f1 \leq f \leq f2$, la tension U1 est négative ou nulle et la tension U2 est positive ou nulle; par conséquent, les diodes D1 et D2 sont bloquées; seule la boucle d'asservissement ASS intervient dans le contrôle de l'oscillateur commandé en tension VCO;
- enfin, lorsque f > f2, les tensions continues U1 et U2 sont négatives; la diode D1 est bloquée et la diode D2 est passante; le moyen M2 agit ainsi sur la commande de l'oscillateur VCO de manière à ce que la boucle de verrouillage de phase PLL2 ainsi formée se verrouille sur la fréquence f2.

Par ce dispositif très simple, la fréquence du signal de sortie du VCO est ainsi toujours ramenée entre f1 et f2 rendant alors possible l'asservissement de celui-ci par la boucle ASS. Les diodes montées en inverse crée en quelque sorte une zone "morte" à l'intérieur de laquelle seule la boucle d'asservissement ASS intervient pour le contrôle de l'oscillateur VCO.

La fréquence de verrouillage f1 et f2 des boucles PLL1 et PLL2 est ajustable en modifiant le facteur de division des diviseurs de fréquence du dispositif et/ou en modifiant la fréquence $f_{ref}$ de l'oscillateur OSC. Bien entendu, lorsque le facteur de division est le même pour les diviseurs DF1 et DF2, comme c'est le cas ici, on peut prévoir de n'utiliser qu'un seul diviseur de fréquence placé en sortie de l'oscillateur OSC.

**Revendications**

1. Dispositif de prépositionnement en fréquence d'un oscillateur (VCO) commandé en tension et comportant une boucle d'asservissement (ASS), lequel dispositif est destiné à prépositionner ledit oscillateur commandé en tension (VCO) dans une plage de fréquences [f1,f2], avec f1<f2, correspondant à la plage de fonctionnement correct de ladite boucle d'asservissement dudit oscillateur, et est caractérisé en ce qu'il comporte des premier et second moyens (M1,M2) formant avec ledit oscillateur commandé en tension (VCO) des première et seconde boucles de verrouillage de phase, lesdites première et seconde boucles de verrouillage de phase étant destinées à verrouiller l'oscillateur commandé en tension sur les fréquences f1 et f2 respectivement, ledit premier moyen (M1) comportant des moyens pour désactiver la première boucle de verrouillage lorsque la fréquence de l'oscillateur commandé en tension (VCO) est supérieure ou égale à f1 et ledit second moyen (M2) comportant des moyens pour désactiver la seconde boucle de verrouillage lorsque la fréquence de l'oscillateur commandé en tension (VCO) est inférieure ou égale à f2.

2. Dispositif selon la revendication 1, caractérisé en ce que le premier moyen (M1) comporte

   - un premier bloc de comparaison (CP1,DF1,DF1',PB1) pour comparer la fréquence de l'oscillateur commandé en tension (VCO) avec la fréquence f1 délivrant une tension de commande positive à l'oscillateur commandé en tension lorsque la fréquence de celui-ci est inférieure à f1, et
   - une première diode (D1) intercalée entre le premier bloc de comparaison et l'oscillateur commandé en tension, ladite première diode étant polarisée de manière à être bloquée et à désactiver la première boucle de verrouillage de phase lorsque la fréquence de l'oscillateur commandé en tension est supérieure ou égale à f1,
     et en ce que le second moyen (M2) comporte
   - un second bloc de comparaison (CP2,DF2,DF2',PB2) pour comparer la fréquence de l'oscillateur commandé en tension (VCO) avec la fréquence f2 délivrant une tension de commande positive à l'oscillateur commandé en tension lorsque la fréquence de celui-ci est inférieure à f2, et
   - une seconde diode (D2) intercalée entre le second bloc de comparaison et l'oscillateur commandé en tension, ladite seconde diode étant polarisée de manière à être bloquée et à désactiver la première boucle de verrouillage de phase lorsque la fréquence de l'oscillateur commandé en tension est inférieure ou égale à f2.

FIG. UNIQUE

**Office européen des brevets**

## RAPPORT DE RECHERCHE EUROPEENNE

Numéro de la demande

EP 98 46 0039

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | US 5 003 272 A (JANTA DIETER J ET AL) 26 mars 1991 * colonne 6, ligne 61 - colonne 7, ligne 41; figures 1,4 * | 1,2 | H03L7/113 |
| X | EP 0 414 260 A (ANRITSU CORP) 27 février 1991 | 1 | |
| A | * page 21, ligne 19 - page 22, ligne 14; figures 9,12 * | 2 | |
| X | US 5 015 970 A (WILLIAMS BERTRAND J ET AL) 14 mai 1991 | 1 | |
| A | * colonne 3, ligne 7 - colonne 5, ligne 59; figure 1 * | 2 | |

**DOMAINES TECHNIQUES RECHERCHES (Int.Cl.6)**

H03L

Le présent rapport a été établi pour toutes les revendications

| Lieu de la recherche | Date d'achèvement de la recherche | Examinateur |
|---|---|---|
| LA HAYE | 11 février 1999 | Ratajski, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)